# EUROPEAN PATENT SPECIFICATION

(11) **EP 0 453 113 B1**
(45) Date of publication and mention of the grant of the patent: **15.05.1996**
(21) Application number: 91302747.0
(22) Date of filing: 28.03.1991
(51) Int. Cl.: H03M 7/40

(54) **Coding and decoding apparatus of variable length date**
Kodier- und Dekodiervorrichtung für Daten variabler Länge
Appareil à coder et décoder pour données de longueur variable

(30) Priority: 28.03.1990 JP 80492/90
(43) Date of publication of application: 23.10.1991
(73) Proprietor: SONY CORPORATION, Tokyo (JP)
(72) Inventor: Shirota, Norihisa, Shinagawa-ku Tokyo (JP)
(74) Representative: Nicholls, Michael John

(56) References cited:
- DE-A- 3 404 436
- DE-A- 3 632 682
- DE-A- 3 736 898
- DE-C- 3 406 624
- US-A- 4 177 456
- US-A- 4 441 183

## Description

The present invention relates to a coding and decoding apparatus for converting data generated with variable length coding such as DCT (discrete cosine transform) or the like into series of data of the predetermined number of bits.

As one of high efficiency coding methods for compressing data amount of digital image signals, two-dimensional DCT has been known. The two-dimensional DCT converts a block of a digital image signal, for example, a block of 8 x 8 in size, into coefficient data in accordance with a particular equation as to remove a redundant component of the signal. The coefficient data is distributed two-dimensionally in the horizontal and vertical directions. In both the directions, the values of low frequency components are large, while the values of the high frequency components are very small. By processing such coefficient data with a variable length coding method such as run-length Huffman encoding, the amount of data to be transferred can be much compressed.

Variable length data where the number of bits differs in each sampled data, such as data which is obtained with the Huffman coding method is not suitable for an coding process of an error correction. Thus, data should be converted into one whose number of bits n is constant (for example, n = 8). Consequently, variable length data is converted into serial data and then the serial variable length data is observed so as to detect a delimitation of each code.

In the conventional method for processing data in bit serial manner, when the number of bits is n, the clock frequency should be n times the sampling frequency of output data. Thus, a high speed circuit which operates at a clock frequency n times the sampling frequency is required.

Therefore, an object of the present invention is to provide a coding circuit for variable length data for converting data whose bit length varies into data whose bit length is constant without providing such a high speed circuit.

Another object of the present invention is to provide a data decoding circuit for detecting a delimitation of each code of a data series arranged into a constant bit length and for converting each code into data of the original length without providing a high speed circuit.

According to an aspect of the present invention, there is provided a coding apparatus for coding variable length data into fixed length words of n bits comprising: first register means for receiving variable length data of up to m bits; shifter means for bit shifting data output from the first register means in accordance with a control signal; composing means for logically combining data output from the shifter means with preceding data output from the composing means; output means for outputting the most significant n bits of the output data of the composing means when the number of bits of the output data from the composing means exceeds n bits; and control signal generating means for generating the control signal in accordance with modulo n of the number of bits of the output data from the composing means; the variable length data being thereby converted into data rearranged in n bit words.

The composing means may include second register means, so that when preceding logically combined data stored in the second register means is less than n bits, the preceding logically combined data and succeeding data output from the shifter means are logically combined and stored in the second register means, and when the preceding logically combined data exceeds n bits, bit data exceeding the n bits of the preceding logically combined data and the succeeding data output from the shifter means are logically combined and stored in the second register means.

According to still another aspect of the present invention, there is provided a decoding apparatus for receiving data rearranged into n bit words and for decoding it into original data corresponding to variable length data, comprising: first shifter means for shifting every n bits of received data by an amount in accordance with a control signal; composing means for logically combining the shifted data with preceding data output from the composing means;
decoding means supplied with logically combined data comprising up to m bits of data, for outputting original data corresponding to the variable m-bit length data, and for outputting information indicating the number of bits of the variable length data; and control signal generating means for generating the control signal in accordance with the information indicating the number of bits of the variable length data.

The control signal generating means may generate a control signal by subtracting the information indicating the number of bits of the variable length data from the preceding control signal.

The preceding data output from the composing means may comprise data from the preceding logical combination operation from which a number of bits have been removed in accordance with the information indicating the number of bits of the variable length data, wherein the removal of the number of bits is performed by a second shifter means.

The decoding apparatus may further comprise means for zero resetting the data output of the first shifter means when the data output from the composing means exceeds the maximum bit length of the variable length data.

The invention will be further described by way of example with reference to the accompanying drawings, in which:-
Fig. 1 is a block diagram of a coding system to which the present invention can be applied;
Fig. 2 is a schematic of data transmission;
Fig. 3 is a block diagram of a coding apparatus;
Figs. 4A and 4B are timing charts showing the operation of the coding apparatus;
Fig. 5 is a schematic of the operation describing the coding apparatus;
Fig. 6 is a schematic exemplifying data series;
Fig. 7 is a block diagram of a decoding apparatus;
Fig. 8 is a timing chart showing the operation of the decoding apparatus; and
Fig. 9 is a schematic describing the operation of the decoding apparatus.

By referring to the accompanying drawings, embodiments of the present invention will be described in the following order.
a. Overall structure
b. Structure of coding apparatus
c. Operation of coding apparatus
d. Structure of decoding apparatus
e. Operation of decoding apparatus
f. Example of modification

### a. Overall structure

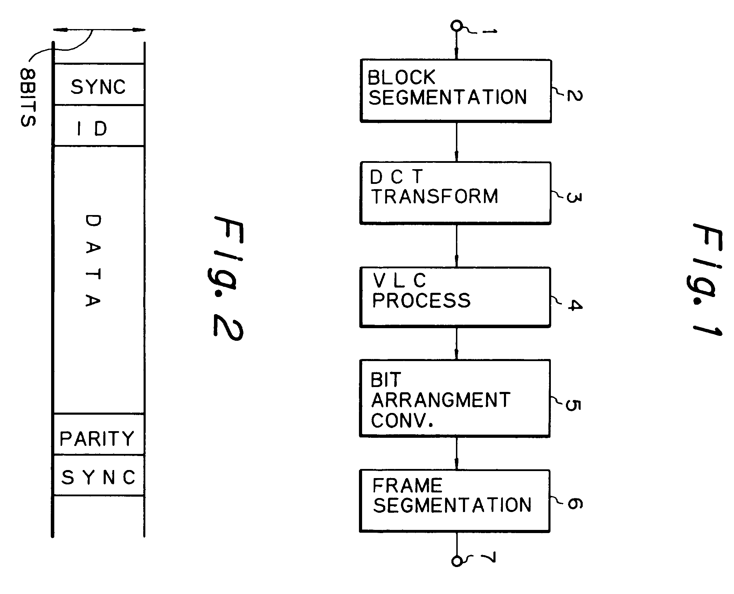

Fig. 1 is a block diagram showing the overall structure of an embodiment of the present invention. A digital video signal is supplied to an input terminal whose reference numeral is 1. A block segmentation circuit 2 converts data sequence from the order of scanning lines into that of blocks. An output signal of the block segmentation circuit 2 is coded by a DCT converter 3. For example, the block segmentation circuit 2 divides one frame picture into a block of (8 x 8). The DCT converter 3 outputs coefficient data of (8 x 8). The coefficient data consists of data of one DC component and data of 63 AC components. The data of AC components is distributed from low frequencies to high frequencies.

The coefficient data of the DCT converter 3 is supplied to a variable length coding circuit 4. The variable length coding circuit 4 is an encoder for run-length Huffman code or the like. An output signal of the variable length coding circuit 4 is supplied to a bit arrangement converting circuit 5. The variable length data is converted into a series of data with a delimitation of a constant bit number (for example, 8 bits). An output signal of the bit arrangement converting circuit 5 is supplied to a frame segmentation circuit 6. An output data is obtained at an output circuit 7 of the frame segmentation circuit 6. The output data is transferred through a communication path. An example of the communication path is a recording apparatus comprising a rotary head and a magnetic tape.

Fig. 2 is a schematic showing an example of data to be transferred. The transmission data is in a byte (8 bits) serial state. A synchronization signal SYNC is located at the beginning of a synchronization block of the transmission data, thereafter identification data ID such as a block address of one synchronization block being present, thereafter coefficient data of a particular amount being present.

In contrast, as opposed to the structure shown in Fig. 1, the receiving side (reproducing side) disassembles frames. The position of the first byte (word) of the data series is detected from the synchronization signal SYNC or the identification data ID therein. The bit arrangement converting circuit restores the words from the beginning into the variable length codes and then decodes the variable length codes into the former fixed length codes.

### b. Structure of coding apparatus

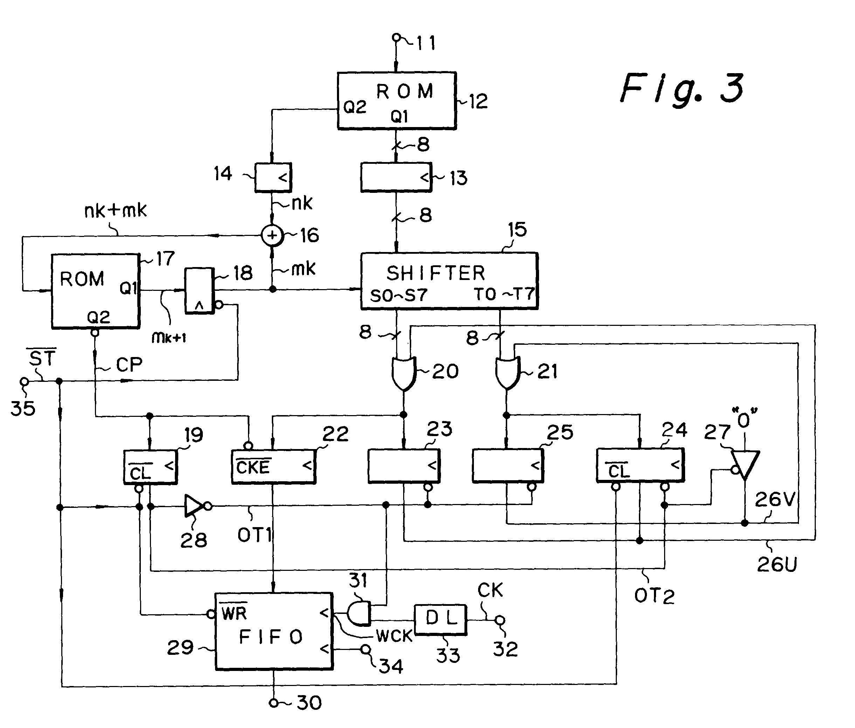

Fig. 3 shows in detail an electric circuit diagram of the variable length coding circuit 4 and the bit arrangement converting circuit 5. In the figure, one sample of input data whose bit number is fixed and which is obtained in the DCT coding operation is supplied to an input terminal whose reference numeral is 11. Coefficient data of around 9 bits is converted into data whose sample is for example 4 bits by a re-quantization circuit. This input data is supplied to a ROM 12. The ROM 12 generates variable length data whose bit length ranges from 0 bit to 8 bits in accordance with the bit pattern of the input data. The present embodiment serves to format variable length data of 8 bits into one word of data series. The variable length data is supplied from an output terminal Q1 of the ROM 12. A control signal representing a significant bit number of one sample of the variable length data is generated at an output terminal Q2 of the ROM 12. The variable length data of the ROM 12 is supplied to a register 13. Thus, the control signal is supplied to a register 14. A shifter 15 is connected to the register 13. A control signal nk (where k = sequence number of time sequence) is supplied from the register to an adder 16. An output signal (nk + mk) of the adder 16 is supplied to a ROM 17. At an output terminal Q1 of the ROM 17, a value mk + 1 of (modulo (mod.) 8) of (nk + mk) is generated. At an output terminal Q2, a 1-bit control signal CP is generated, the signal going low (low level) when (nk + mk) >₌ 8. This control signal CP represents that one word is made from the variable length data.

An output signal mk + 1 of the ROM 17 is supplied to a register 18. A control signal mk of the register 18 is supplied to the shifter 15 and the adder 16. In addition, a control signal CP is supplied to a register 19. The shifter 15 is a circuit with a width of 16 bits. The shifter 15 shifts the data from the register 13 to the right for the number of bits in accordance with the control signal mk. The bits which are output from the shifter 15 and which are not output from the register 13 are 0's.

8-bit parallel data S0 to S7 and T0 to T7 of the shifter 15 are supplied to OR gates 20 and 21, respectively. An output signal of the OR gate 20 is supplied to registers 22 and 23. An output signal of the register 21 is supplied to registers 24 and 25. Output signals of the registers 23 and 24 are supplied to the OR gate 20 through a bus 26U. Output signals of the register 25 and a gate 27 are supplied to the OR gate 21 through a bus 26V. The gate 27 outputs 8 bits which are all 0's to the bus 26V in accordance with an output control signal OT2.

An output control signal OT1 where the control signal CP held in the register 19 is inverted by an inverter 28 is supplied to the registers 23 and 25. The registers 23 and 25 output the respective contents to the buses 26U and 26V when the output control signal OT1 goes "L". In other words, the output control signal OT1 is a low active signal. As shown in the figure, a bar mark ("-") has to be placed over the signal OT1. However, to simplify the appearance of the specification, it is omitted. Likewise, for other low active signals, the mark-is also omitted. The output control signal OT2 of the register 19 is supplied to the register 24 and the gate 27. The register 24 outputs the content to the bus 26U when the control signal OT2 goes "L". The gate 27 outputs "0" data to the bus 26V when the control signal OT2 goes "L". The control signal CP is supplied to the register 22 as a clock enable signal. When the control signal CP goes "L", the clock signal to the register 22 is enabled and thereby data is latched by the register 22.

An output signal of the register 22 is supplied to a FIFO memory 29. The FIFO memory 29 absorbs the difference of the data rate between the 8-bit data which is generated by the register 22 and the data obtained at the output terminal 30 as to generate output data at a fixed data rate. A write clock signal WCK of the FIFO memory 29 is supplied through an AND gate 31. The output control signal OT1 and the clock signal CK, which is supplied from an input terminal 32 through a delay circuit 33, are supplied to the AND gate 31. A read clock signal of the FIFO memory 29 in accordance with the output data is supplied from an input terminal 34.

A start signal ST is supplied from an input terminal 35. When the start signal ST goes "L", the contents of the registers 18, 19, and 24 are cleared; the FIFO memory 29 is write-reset; and the write address is set to address 0.

### c. Operation of Encoding Apparatus

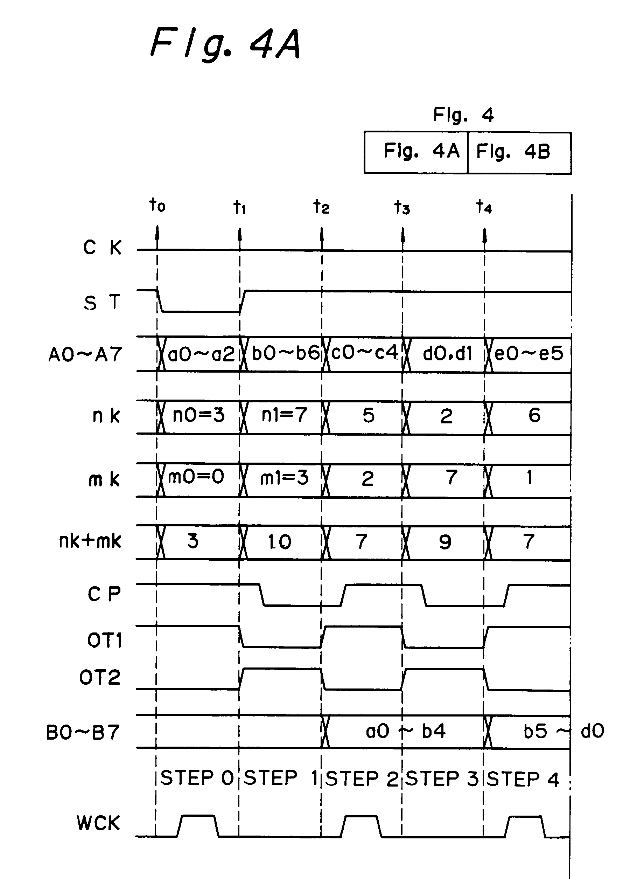

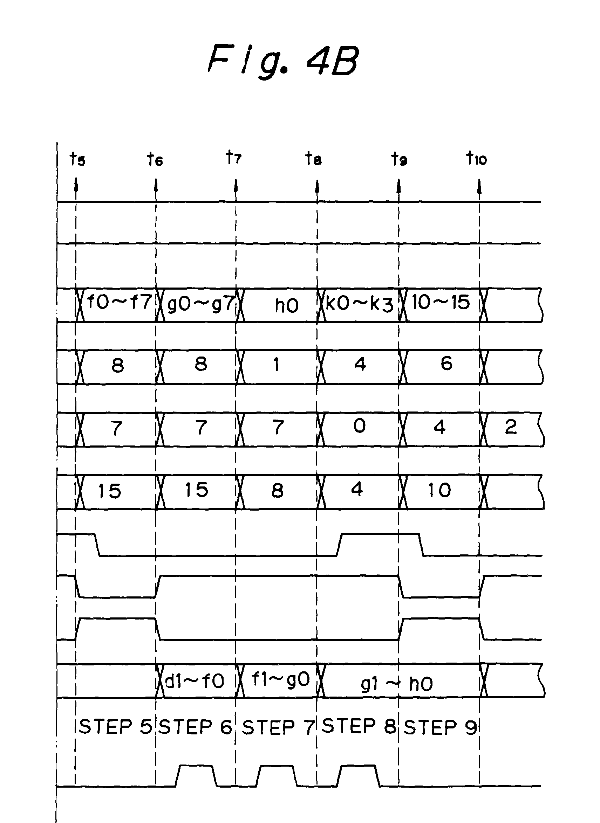

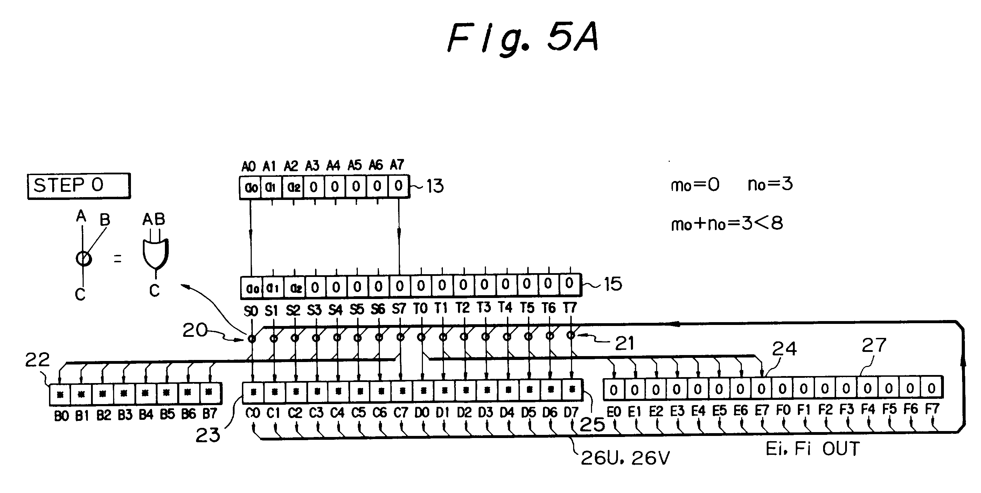

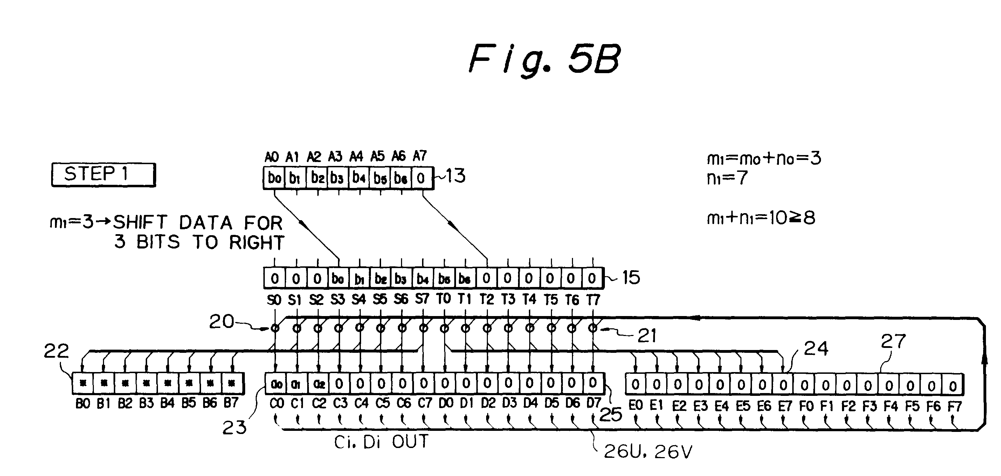

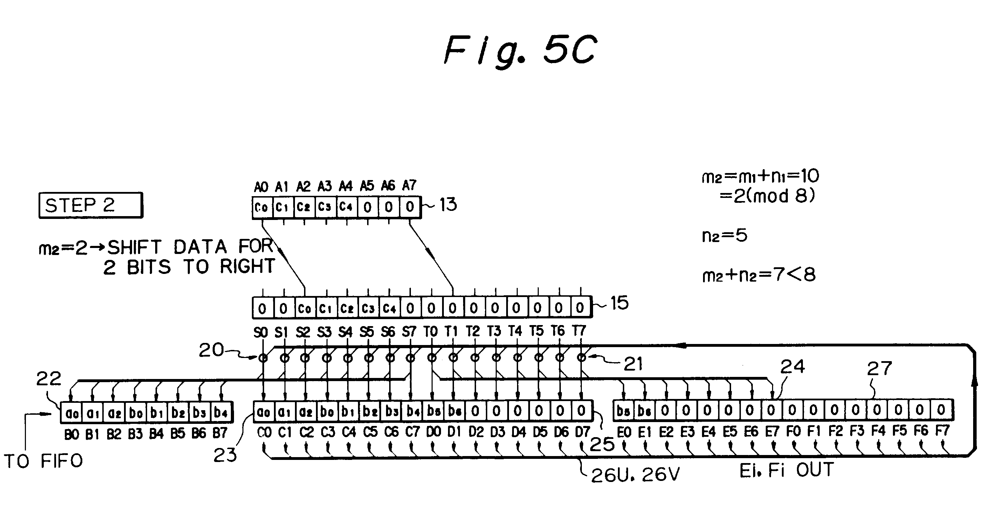

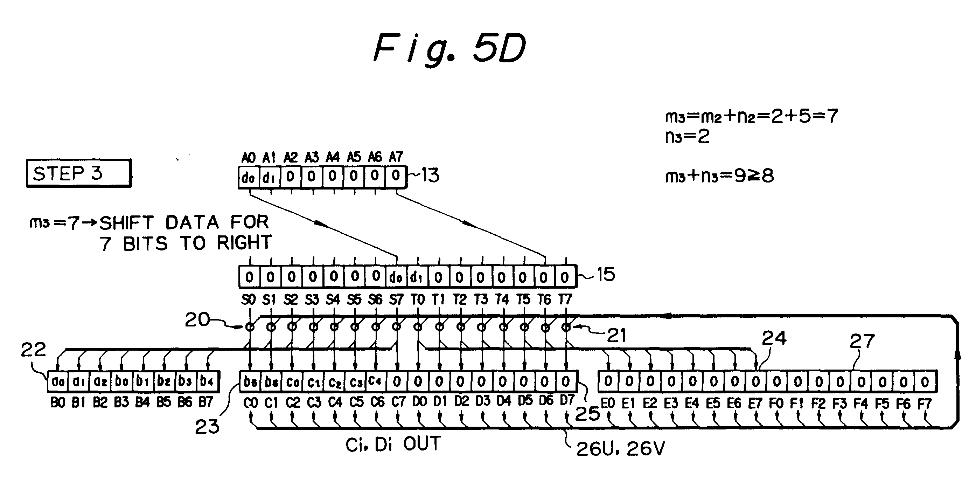

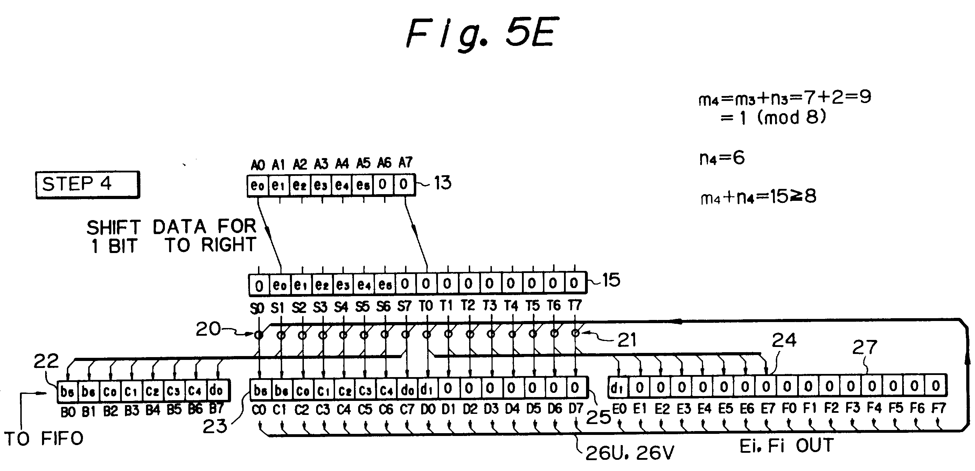

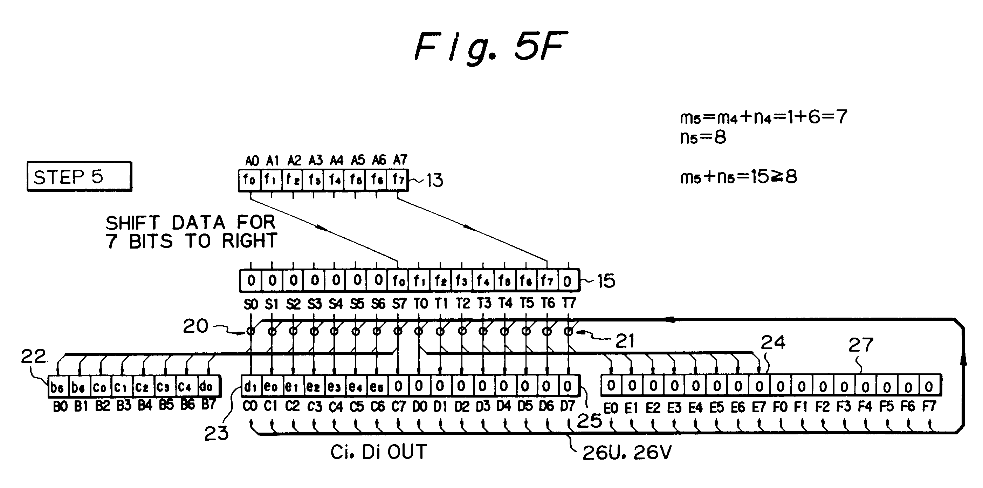

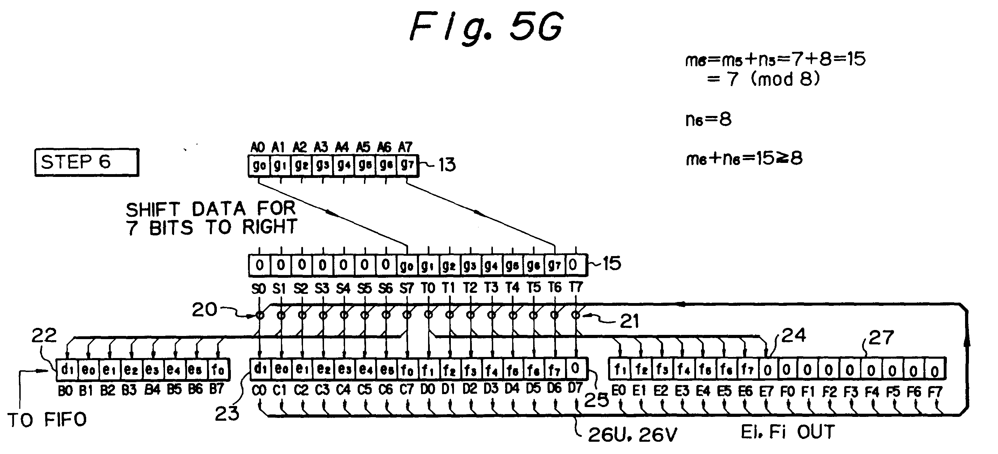

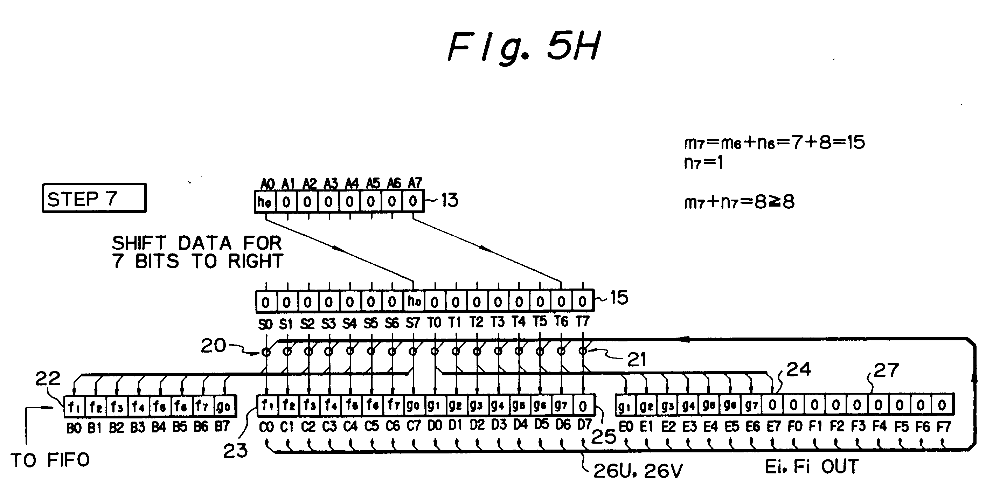

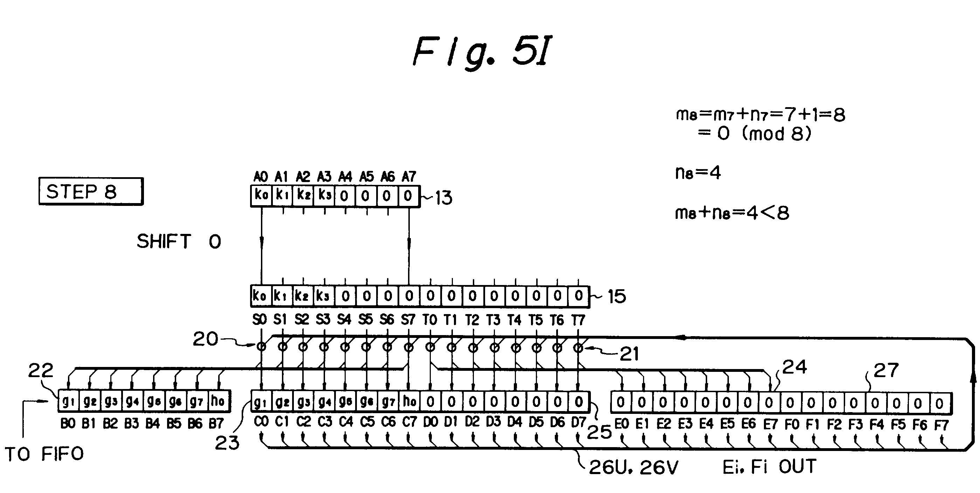

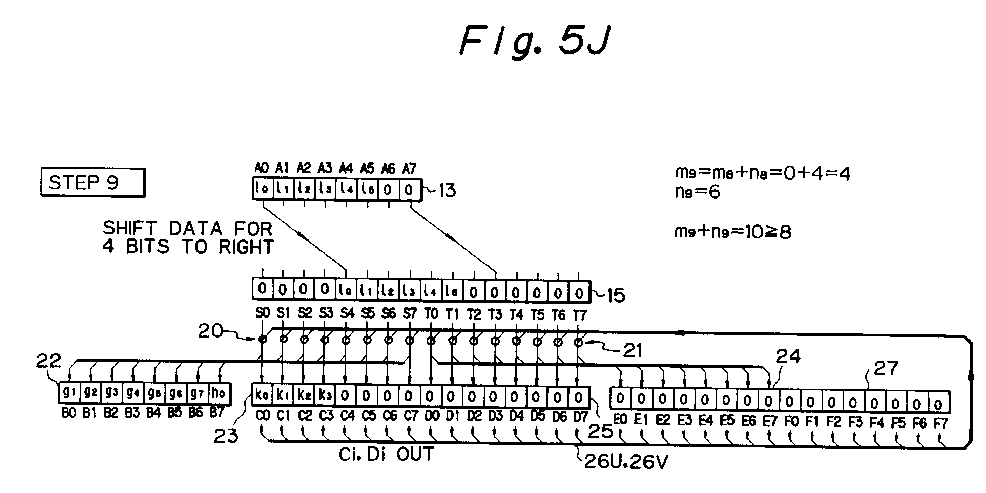

Fig. 4 is a timing chart showing the operations in the structure shown in Fig. 3. Fig. 4 shows the clock signal CK, the start signal ST, the output signal A0 to A7 of the register 13 (the variable length data generated in the ROM 12), the output signal (control signal) nk of the register 14, the output signal (control signal) mk of the register 18, the output signal (nk + mk) of the adder 16, the control signal CP which is output from the ROM 17, the output control signal OT1, the output control signal OT2, the output signal B0 to B7 of the register 22, and the write clock signal WCK of the FIFO memory 29 from the top thereof. The processes defined with timings t0, t1, ... , and t9 by the clock signal CK are referred to as step 0, step 1, ... , and step 9. The output signal of the register 13, the output signal of the shifter 15, and the output signals of the registers 22, 23, 24, and 25, and the output signal of the gate 27 are shown in Figs. 5A to 5J. C0 to C7 are the 8-bit output signal of the register 23. D0 to D7 are the 8-bit output signal of the register 25. E0 to E7 are the 8-bit output signal of the register 24. F0 to F7 are the 8-bit output signal of the gate 27. In Fig. 5, the OR gates 20 and 21 are marked with circles for simplifying the schematic. The asterisks (*) in the figure represent uncertain data.

In the step 0, namely the timing t0, the start signal ST goes low. With the start signal ST, the contents of the registers 18, 19, and 24 are cleared. Thus, it means that the control signal m0 becomes zero data, that the shift amount of the shifter 15 is set to 0, and that the output control signals OT1 and OT2 go "H" (in the high level) and "L" (in the low level), respectively. Thus, the output signal (E0 to E7), which is zero data, of the register 24 is output to the bus 26U. The zero data (F0 to F7) is output to the bus 26V through the gate 27. Consequently, the values of the buses 26U and 26V become 0. On the other hand, since the start signal ST is supplied to the FIFO memory 29 as the write reset signal WR, the write address of the FIFO memory 29 is set to the address 0.

As shown in Fig. 5A, the output signal A0 to A7 of the register 13 are samples a0 to a2 of the first three bits of the variable length data. The control signals are (n0 = 3) and (m0 = 0). The output signal of the adder 16 is (n0 + m0 = 3). The output signal of the adder 16 is supplied to the ROM 17. The numeral 3 of (mod. 8) is 3 and thereby the value at the output terminal Q1 of the ROM 17 is also 3. The value 3 is output from the register 18 as the control signal m1 in the subsequent step 1.

The control signals nk and mk represent:
nk : the number of significant bits of k-th data being output from the register 13.
mk : the number of bits of significant data which is output in left-alignment to the busses 26U and 26V.

Thus, to avoid the output data of the register 13 at the OR gates 20 and 21 from colliding with that from the bus 26U and 26V, the output data of the shifter 13 is shifted to the right for mk bits by the shifter 15.

The data value in the step 1 is shown in Fig. 5B. Since 7 bits of variable length data b0 to b6 are generated by the register 13 in the step 1, the control signal n1 becomes 7. Since the shifter control signal is (m1 = 3), the shifter 15 shifts the data for 3 bits to the right. Thus, 3 bits (S0 to S2) of the output signal from the shifter 15 are "0"; and 5 bits (S3 to S7) and 2 bits (T0 and T1) of the output signal from the shifter 15 become data b0 to b6. In the step 0, the data a0 to a2 has been transferred to the register 23. The data a0 to a2 and the data b0 to b7 are composed by the OR gates 20 and 21 without an overlap. The output signal of the OR gate 20 is latched by the register 23 with the subsequent clock t2. The output signal of the OR gate 21 is latched by the registers 24 and 25 with the clock t2.

The adder 16 generates the output signal (n1 + m1 = 7 + 3 = 10). The output signal m2 of the ROM 17 is changed to (10 = 2 (mod. 8)). On the other hand, since (10 >₌ 8), namely the significant data composed by the OR gates 20 and 21 in the step 1 exceeds one word or eight bits, the control signal CP (see Fig. 4) goes "L".

In the step 2, as shown in Fig. 5C, the subsequent 5 bits of data c0 to c4 are generated by the register 13 and thereby the control signal (n2 = 5) is generated. Since (m2 = 2), the shifter 15 shifts the data for 2 bits to the right. The output signal (n2 + m2 = 5 + 2 = 7) of the adder 16 is generated.

In the former step 1, the control signal CP which goes "L" has been supplied to the register 22 as the clock enable signal. Thus, as shown in Fig. 5C, the 8 bits of the output signal (a0 to b4) from the OR gate 20 are latched by the register 22 with the clock t2. In addition, since the control signal CP ("L") is latched by the register 19 with the clock t2, the output control signals OT1 and OT2 go "H" and "L", respectively. Since the output control signal OT1 goes "H", the write clock signal WCK is supplied to the FIFO memory 29 through the AND gate 31. Thus, the output signal (8 bits of parallel data a0 to b4) of the register 22 is written to the address 0 of the FIFO memory 29.

In the step 2, since (OT2 = "L"), the output signal (b5 and b6) of the register 24 is output to the bus 26U and the output signal (zero data) of the gate 27 is output to the bus 26V. On the other hand, since (OT1 = "H"), the output signal (a0 to b4) of the register 23 is not output to the bus 26U. In other words, the 8 bits of data (a0 to b4) which are written in the FIFO memory 29 are not processed in the later processes and the data (b5 and b6) which has not been written is output to the bus 26U.

In the step 3, as shown in Fig. 5D, the subsequent 2 bits of data d0 and d1 are generated by the register 13 and thereby the control signal (n3 = 2) is generated. Since (m3 = 7), the shifter 15 shifts the data for 7 bits to the right. The adder 16 generates the output signal (n3 + m3 = 2 + 7 = 9).

In the preceding step 2, since the control signal CP goes "H", the content of the register 22 is not changed. In addition, since the control signal CP ("H") is latched by the register 19 with a clock t3, the output control signals OT1 and OT2 go "L" and "H", respectively. Since the output control signal OT1 goes "L", the write clock signal WCK is not supplied to the FIFO memory 29. Thus, the output signal of the register 22 is not written to the

FIFO memory 29.

In the step 3, since (OT1 = "L"), the output signal (b5 to c4) of the register 23 is latched with the clock t3 and then output to the bus 26U, while the output signal of the register 25 (zero data latched with the clock t3) is output to the bus 26V.

The operations in the steps 4 to 9 which are conducted when 6 bits of data e0 to e5, 8 bits of data f0 to f7, 8 bits of data g0 to g7, 1 bit of data h0, 4 bits of data k0 to k3, and 6 bits of data 10 to 15 are latched by the register 13 are same as those in the steps 1 to 3 above. The output signals of the registers in the steps 4 to 9 are the same as those shown in Figs. 5E to EJ. The description of such operations is omitted to prevent redundancy.

The operation in accordance with the above embodiment is summarized as follows. When the output signal composed by the OR gates 20 and 21 becomes significant data of 8 bits or more, the output signal of the OR gate 20 is latched by the register 22 and written to the FIFO memory 29. The output signal of the OR gate 21 is latched by the register 24. In the subsequent step, 8 bits of data with all "0" of the gate 27 and the output signal of the register 24 are output to the buses 26U and 26V, respectively. On the other hand, when the output signals composed by the OR gates 20 and 21 are less than 8 bits, the output signals of the OR gates 20 and 21 are latched by the registers 23 and 25, respectively. The signals are fed back to the OR gates 20 and 21 through the buses 26U and 26V and then composed with the output signal of the shifter 15. This composing operation is repeated until the output signals of the OR gates 20 and 21 exceed 8 bits.

According to the embodiment described above, since data coded as variable length codes is processed as parallel data, and converted into a parallel data series where one word consists of constant number of bits (for example, 8 bits), the clock frequency of the operation is lower than that processed as serial data. Thus, it is possible to use a low speed process circuit.

### d. Structure of decoding apparatus

Now, an embodiment of a decoding apparatus for detecting a delimitation of each variable length code from 8 bits of data, which are 1 word of data and for converting each code into 4 bits of fixed data will be described.

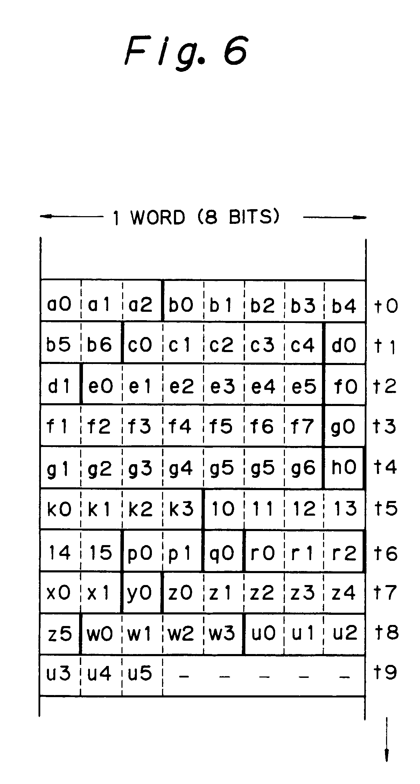

Fig. 6 exemplifies a data series generated by the aforementioned coding circuit. The position of the first bit a0 of the first word (byte) can be detected with a pattern of synchronization signal. Thus, the decoding apparatus can decode the first word.

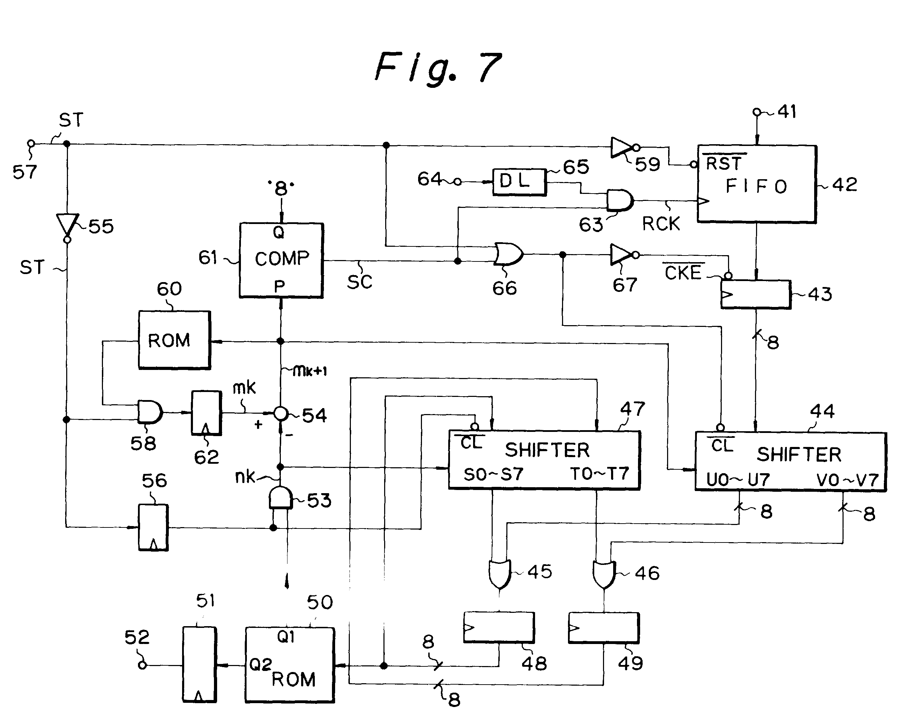

In the embodiment of the decoding circuit shown in Fig. 7, a data series shown in Fig. 6 is supplied to an input terminal 41. Input data is written to an FIFO memory 42. Data being read from the FIFO memory 42 is latched by a register 43. An output signal of the register 43 is supplied to a shifter 44. Output signals U0 to U7 and V0 to V7 of the shifter 44 are supplied to OR gates 45 and 46, respectively. Output signals S0 to S7 and T0 to T7 of another shifter 47 are supplied to the OR gates 45 and 46, respectively. An output signal of the OR gate 45 is latched by a register 48. An output signal of the OR gate 46 is latched by a register 49.

An output signal of the register 48 is fed back to an input terminal of the shifter 47 and also supplied to a ROM 50. An output signal of the register 49 is fed back to another input terminal of the shifter 47. The ROM 50 decodes variable length codes. The ROM 50 checks the variable length codes from the low order bit as to detect a delimitation of each code. At an output terminal Q1 of the ROM 50, a control signal representing the bit length of variable length codes is obtained. In addition, by decoding the variable length codes, at an output terminal Q2 of the ROM 50, decoded data of former 4 bit fixed length is obtained. The decoded data is obtained at an output terminal 52 through a register 51.

A control signal of the ROM 50 is supplied to an AND gate 53. A control signal nk of the AND gate 53 is supplied to the shifter 47 and a subtracter 54. The shifter 44 shifts the input data for the number of bits designated with the control signal nk to the left. An inverted start signal is supplied from a terminal 57 to the AND gate 53 and a clear terminal of the shifter 47 through an inverter 55 and a register 56. The start signal inverted by the inverter 55 is supplied to an AND gate 58. The start signal ST is supplied to the FIFO memory 42 as a read reset signal. A read address of the FIFO memory 42 is set to address 0 with the read reset signal.

An output signal mk + 1 (= mk - nk) of the subtracter 54 is supplied to the shifter 44, a ROM 60, and a comparator 61. The shifter 44 shifts the input data supplied from the resister 43 for mk + 1 bits to the right. When the subtraction output signal mk + 1 is (mk + 1 <₌ 8), the ROM 60 generates a value of (mk + 1 + 8). An output signal of the ROM 60 is supplied to the AND gate 58 along with the inverted start signal. An output signal of the AND gate 58 is supplied to a register 62. An output signal mk of the register 62 is supplied to the subtracter 54.

When the value of 8 is always supplied to the comparator 61 as one input signal and the subtraction output signal mk + 1 is (mk + 1 <₌ 8), it generates a comparison output signal SC which goes "H". This comparison output signal SC is supplied to an AND gate 63 and an OR gate 66. A word clock signal of a terminal 64 is supplied to the FIFO memory 42 through a delay circuit 65 and the AND gate 63 as a read clock signal RCK. Thus, when the control signal SC goes "H", the read clock signal RCK is supplied to the FIFO memory 42 and then the content of the FIFO memory 42 is read.

An output signal of the OR gate 66 where the comparison output signal SC of the comparator 61 and the start signal ST are supplied is supplied to the shifter 44 as a clear signal and to the register 43 through an inverter 67 as a clock enable signal. Thus, when the output signal of the OR gate 66 goes "H", it latches the output signal supplied from the FIFO memory 42.

In the decoding apparatus shown in Fig. 7, the 8 bits composed by the OR gate 45 are supplied from the register 48 to the ROM 50. By checking the 8 bits from the low order bit, a delimitation of each code can be detected and thereby each code is decoded to the former 4-bit data. In accordance with the delimitation being detected, the ROM 50 generates the control signal nk. Thus, after the nk-bit code has been decoded, the nk bits stored in the register 48 become unnecessary. The subsequent (8 - nk) bits are codes to be decoded.

However, the subsequent code may be longer than (8 - nk) bits. Thus, in the subsequent step, the register 48 should have to provide 8 significant bits. To compensate the insufficient bits of data, the OR gate 46 and the register 49 are provided. The 16 bits of data stored in the registers 48 and 49 are shifted to the left for nk bits in accordance with the control signal nk generated by the ROM 50. In other words, the unnecessary nk bits in the register 48 are discarded. In addition, when the registers 48 and 49 store mk significant bits, the nk bits are discarded in the subsequent step as was described above.

In addition, when the output signal mk + 1 (= mk - nk) <₌ 8, as a result of the shift operation by the shifter 47, the significant data is not supplied to the register 49. To prevent that, the 8 bits stored in the register 43 are shifted for mk + 1 bits to the right by the shifter 44 and then the resultant data is composed with the output signals of the shifter 47 by the OR gates 45 and 46. Thus, the first bit of the significant data from the shifter 44 is preceded by the last bit of the shifter 47. Consequently, in the subsequent step, new significant (mk - nk + 8) bits are stored in the registers 48 and 49. By repeating the aforementioned operations, the variable length codes can be continuously decoded.

### e. Operation of decoding apparatus

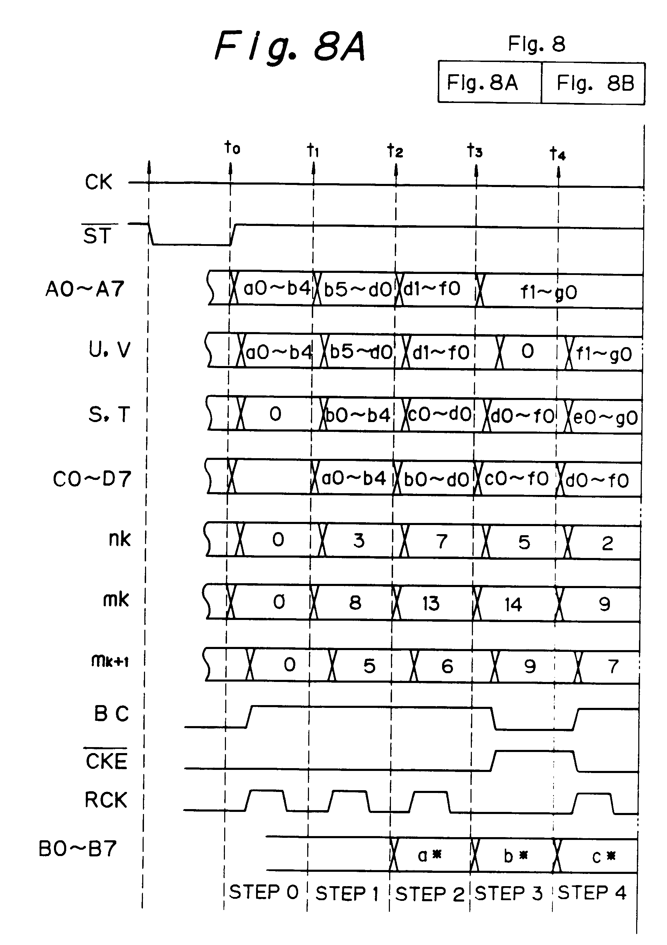

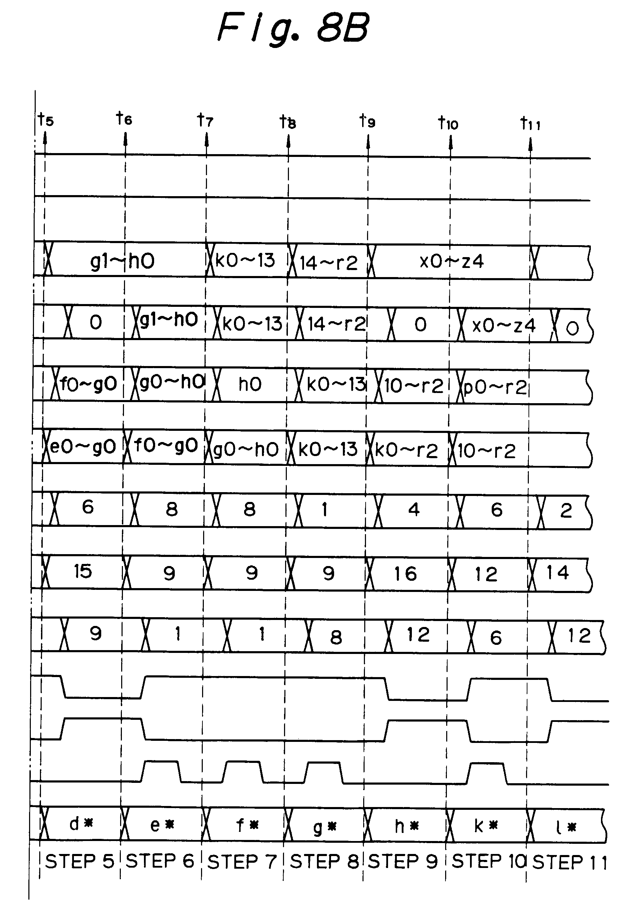

Fig. 8 is a timing chart showing the operations in the structure shown in Fig. 7. The figure shows the word period clock signal CK, the start signal ST, the output signal A0 to A7 of the register 43, the output signals U0 to U7 and V0 to V7 of the shifter 44, the output signals S0 to S7 and T0 to T7 of the shifter 47, the output signals C0 to C7 and D0 to D7 of the registers 48 and 49, the control signal nk of the AND gate 53, the output signal mk of the register 62, the output signal (mk - nk = mk + 1) of the subtracter 54, the comparison output signal SC of the comparator 61, the clock enable signal of the register 43 (the output signal of the inverter 67), the read clock signal RCK of the FIFO memory 42, and the output signal B0 to B7 of the register 51 from the top in succession. The processes defined with timings t0, t1, ... , and t11 by the clock signal CK are referred to as step 0, step 1, ... , and step 11.

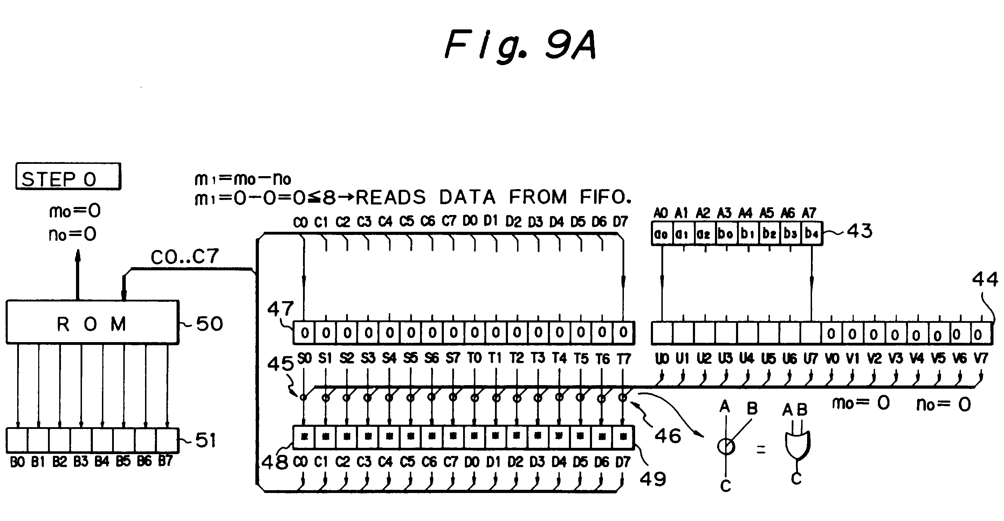

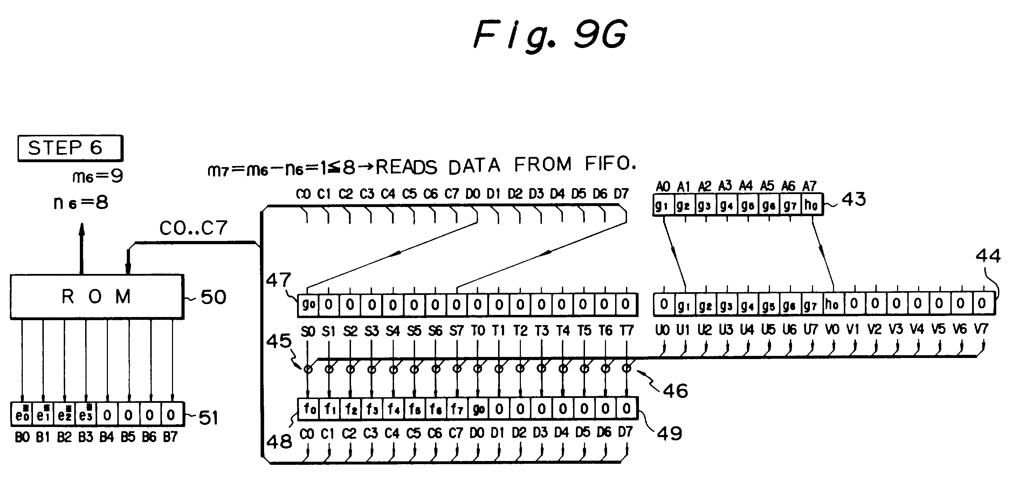

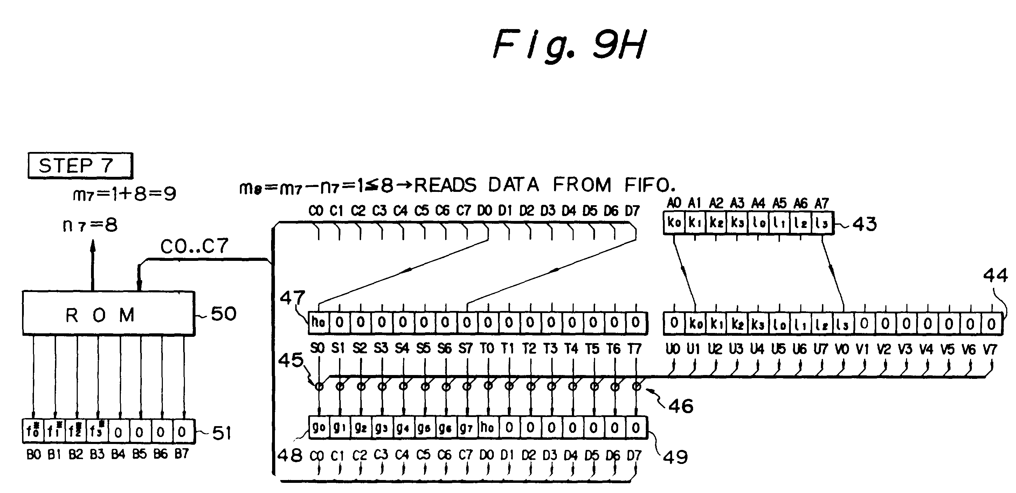

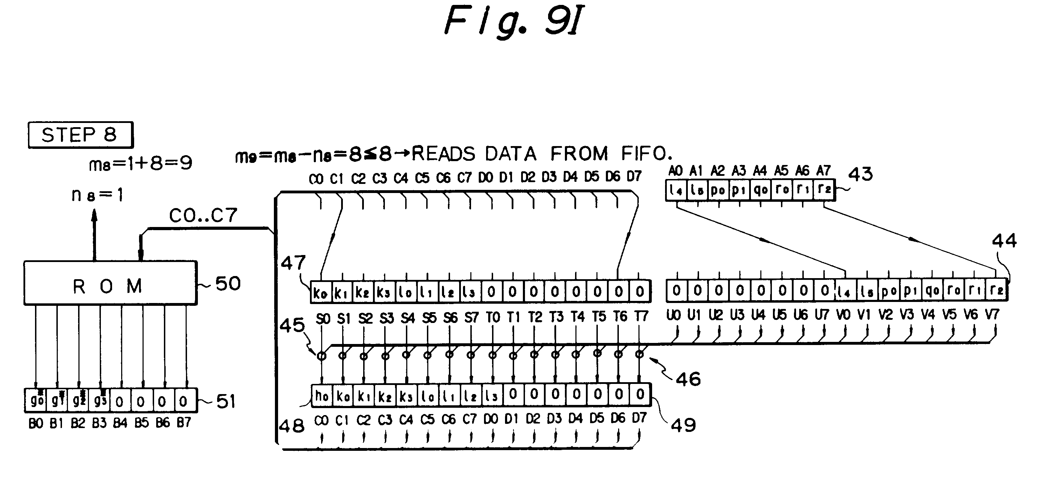

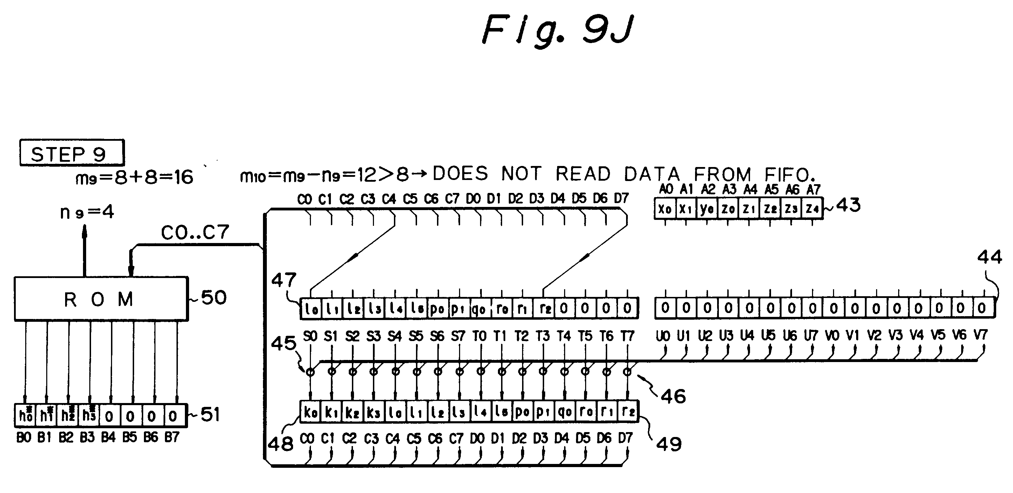

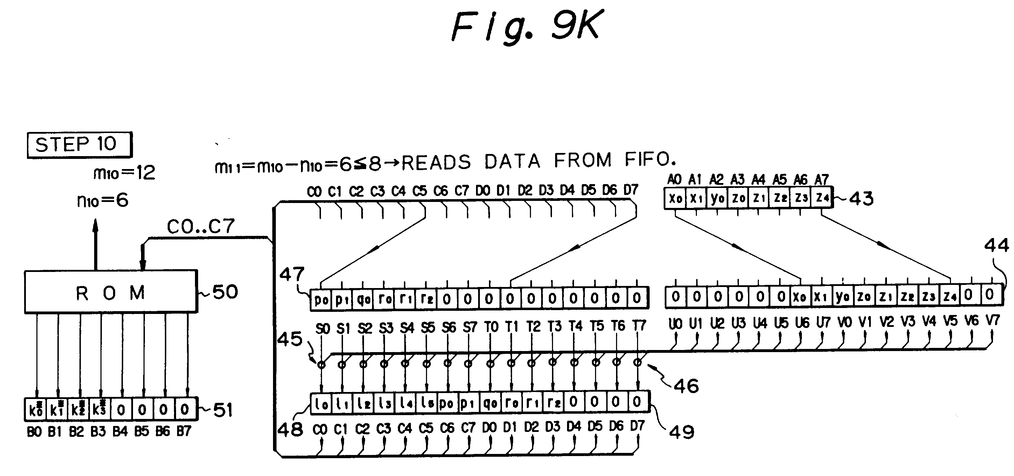

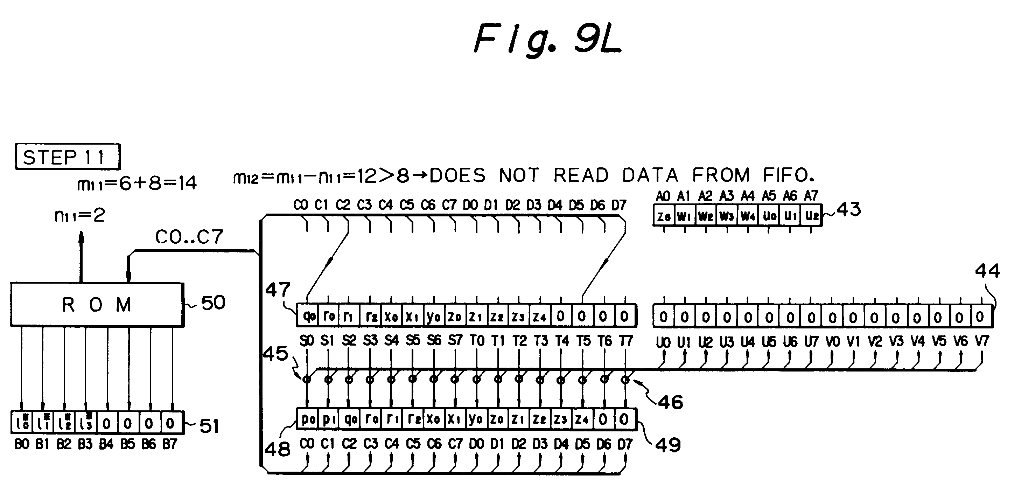

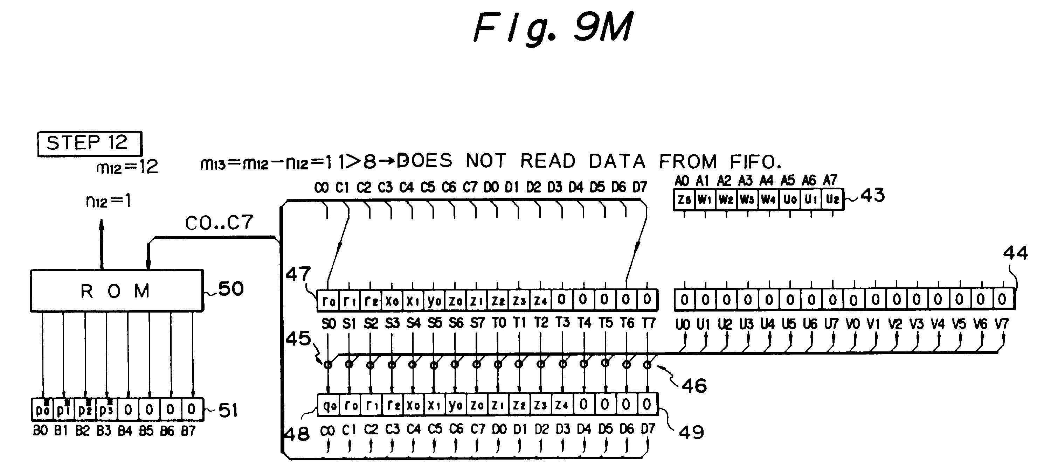

The output signals of the register 43, the shifters 44 and 47, the registers 48 and 49, and the ROM 50 are shown in Figs. 9A to 9M. In Figs. 9A to 9M, A0 to A7 represent 8 bits of the output signal of the register 43; B0 to B7 represent 8 bits of the output signal of the register 51; C0 to C7 represent 8 bits of the output signal of the register 48; and D0 to D7 represent 8 bits of the output signal of the register 49. In Figs. 9A to 9M, the OR gates 45 and 46 are represented with circles for simplifying the schematics and 4-bit long data being decoded is represented with the asterisk mark (*). As an example, 4 bits of data where 3 bits of the variable length data a0 to a2 were decoded are represented with a0* to a3*.

With a clock preceding the timing t0, the start signal ST goes "H" and the inverted signal goes "L". Since the start signal is supplied to the FIFO memory 42 as the read reset signal RST, the read address of the FIFO memory 42 is set to address 0. In addition, since the comparison output signal SC is in the "H" level, the first word is read from the address 0 of the FIFO memory 42. With a clock of the subsequent timing t0 (in the step 0), the first word (a0 to b4) is latched by the register 43 as shown in Fig. 9A.

In the step 0, since the output signals of the registers 56 and 62 are 0, n0 and m0 are 0 and m1 is also 0. Thus, the shift amount of the shifters 44 and 47 is 0. In addition, the output signal of the register 56 causes the shifter to be cleared. All the 16 bits of the output signals of the shifter 47 become "0" regardless of their input signals. Thus, the output signal of the OR gate 45 becomes (a0 to b4) and thereby the output signal of the OR gate 46 becomes zero data.

In addition, since m1 = 0, namely (m1 <₌ 8), the comparison output signal SC goes "H". The read clock signal RCK of the AND gate 63 is output to the FIFO memory 42. The second word (b5 to d0) at the address 1 is read from the FIFO memory 42. At the time, since the clock enable signal of the register 43 is in the "L" level, with a clock of the subsequent timing t1, the register 43 latches the second word. In addition, since (m1 = 0 <₌ 8), the ROM 60 generates the value of (0 + 8).

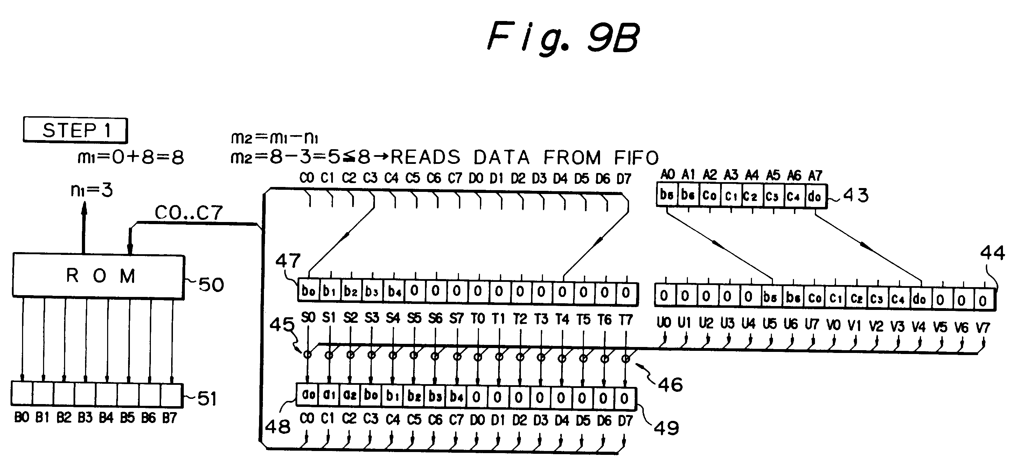

In the step 1 of the timing t1, as shown in Fig. 9B, the output signal A0 to A7 of the register 43 is (b5 to d0); the output signal C0 to C7 of the register 48 is (a0 to b4); and the output signal of the register 49 is zero data.

The output signal of the register 48 is supplied to the ROM 50. The ROM 50 determines that 3 bits of (a0, a1, a2) are 1 code of the variable length data and generates 4 bits of decoding data (a0*, a1*, a2*, and a3*). In addition, the ROM 50 generates a control signal of (n1 = 3). The 4 bits are latched by the register 51 with a clock of the subsequent timing t2. Since the 3 bits (a0, a1, and a2) being decoded are not necessary in the subsequent step 2, the shifter 47 shifts the data for 3 bits to the left and thereby the 3 bits are discarded. Thus, the 5 bits of (b0 to b4) are output from the left end of the shifter 47.

Since the output signal m2 of the subtracter 54 is (m1 - n1 = 5 <₌ 8), the shifter 44 shifts the data for 5 bits to the right. When the output signals of the shifter 44 are composed with those of the shifter 47 by the OR gates 45 and 46, the bit b4 is followed by the bit b5. Thus, the significant 13 bits (b0 to d0) are output from the OR gates 45 and 46. In this case, the output signal of the ROM 60 becomes (m3 = 13). With a clock of the subsequent timing t2, the number of significant bits which are latched by the registers 48 and 49 is shown.

Since the comparison output signal SC is (m2 = 5 <₌ 8), the signal goes "H". Thus, the read clock signal RCK is supplied to the FIFO memory 42 and the next word (d1 to f0) is output. This word is latched by the register 43 with the clock of the subsequent timing t2.

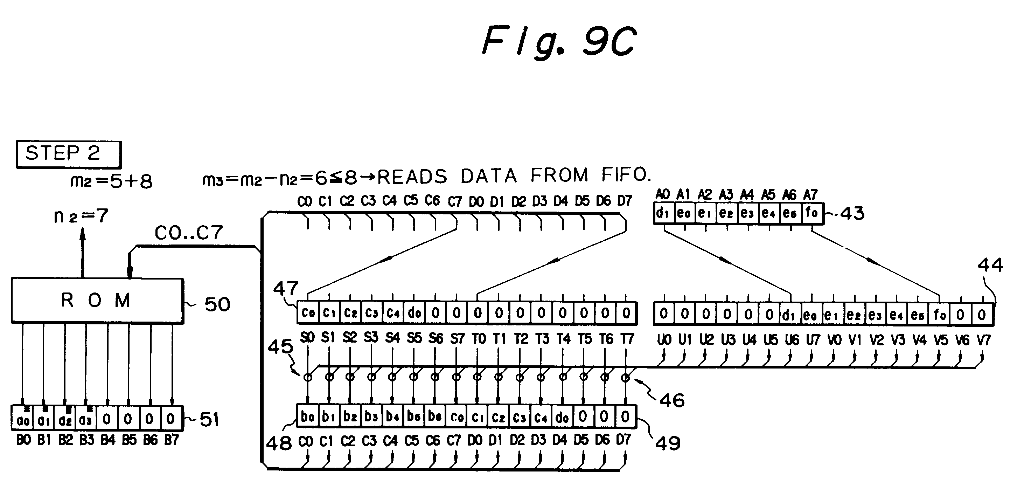

In the step 2 of the timing t2, as shown in Fig. 9C, the output signal A0 to A7 of the register 43 is (d1 to f0); the output signal C0 to C7 of the register 48 and the output signal D0 to D7 are (b0 to d0); and the output signal B0 to B7 of the register 51 is (a0* to a3*).

The output signal of the register 48 is supplied to the ROM 50. The ROM 50 determines that 7 bits of (b0 to b6) are 1 code of the variable length data and generates 4 bits (b0* to b3*) of the decoded data. In addition, the ROM 50 generates the control signal (n2 = 7). The 4 bits are latched by the register 51 with a clock of the subsequent timing t3. Since the 7 bits (b0 to b6) being decoded become unnecessary in the subsequent step 3, the shifter 47 sifts the data for 7 bits to the left with the control signal n2. Thus, the 7 bits are discarded. The 6 bits (c0 to d0) are output from the left end of the shifter 47.

The output signal m3 of the subtracter 54 is (m2 - n2 = 13 - 7 = 6 <₌ 8) and thereby the shifter 44 shifts the data for 6 bits to the right. When the output signals of the shifter 44 are composed with those of the shifter 47 by the OR gates 45 and 46, the bit d0 is followed by the bit d1. Thus, the significant 14 bits (c0 to f0) are output from the OR gates 45 and 46. In this case, the output signal of the ROM 60 becomes (m3 = 14). With a clock of the subsequent timing t3, the number of significant bits latched by the registers 48 and 49 is shown.

Since the comparison output signal SC is (m2 = 6 <₌ 8), the signal goes "H". Thus, the read clock signal RCK is supplied to the FIFO memory 42 and then the subsequent word (f1 to g0) is output. This word is latched by the register 43 with a clock of the subsequent timing t3.

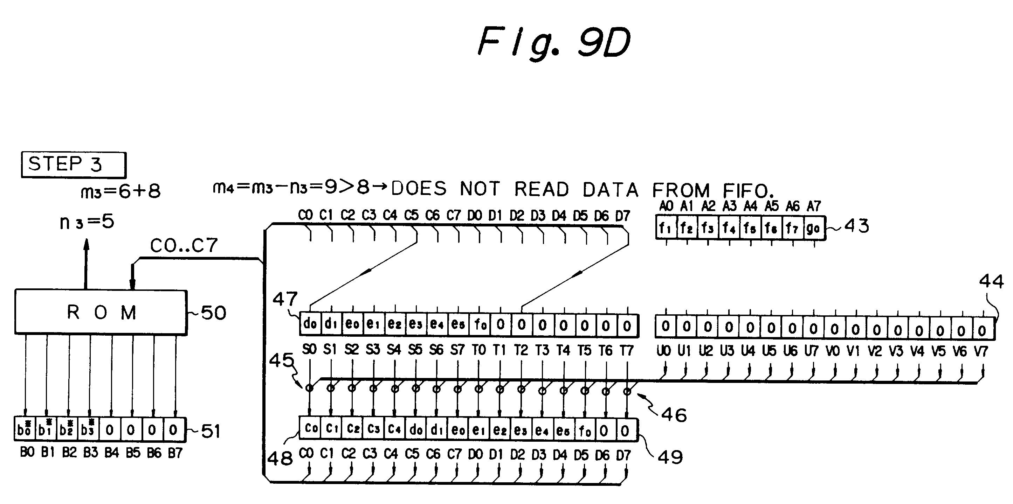

In the step 3 of the timing t3, as shown in Fig. 9D, the output signal A0 to A7 of the register 43 is (f1 to g0). The output signal C0 to C7 of the register 48 and the output signal D0 to D7 are (f1 to g0) and (c0 to f0), respectively. The output signal B0 to B7 of the register 51 is (b0* to b3*).

The output signal of the register 48 is supplied to the ROM 50. The ROM 50 determines that the 5 bits (c0 to c4) are 1 code of the variable length data and generates 4 bits (c0* to c3*) of the decoded data and the control signal (n3 = 5). The 4 bits are latched by the register 51 with a clock of the subsequent timing t4. Since the 5 bits (c0 to c4) being decoded become unnecessary in the subsequent step 4, the shifter 47 shifts the data for 5 bits to the left with the control signal n3 and discards the 5 bits. Thus, the shifter 47 outputs the 9 bits (d0 to f0) from the left end.

In the step 3, the output signal m4 of the subtracter 54 is (m3 - n3 = 14 - 5 = 9 > 8) and the comparison output signal SC goes "L". Thus, the content of the shifter 44 is cleared. As shown in Fig. 9D, the output signal of the shifter 44 becomes zero data regardless of the input signal. The output signal of the ROM 60 is kept 9 (without an addition of 8).

The reason why the content of the shifter 44 is cleared is as follows. As was described above, in the registers 48 and 49, even if the 5 bits are discarded, the remaining 9 bits are larger than the number of bits for determining the length of the variable length codes (8 bits). Thus, it is necessary for the shifter 47 to shift the output signals of the registers 48 and 49 for 5 bits to the left. In the subsequent step 4, it is necessary to decode the variable length codes with the 9 bits. Thus, although the subsequent word is latched by the register 43, the output signal of the shifter 44 is forcedly set to zero data which is used in the step 4. In addition, since the comparison output signal SC is in the "L" level, the read clock signal RCK is not supplied to the FIFO memory 42 and thereby data is not read from the FIFO memory 42.

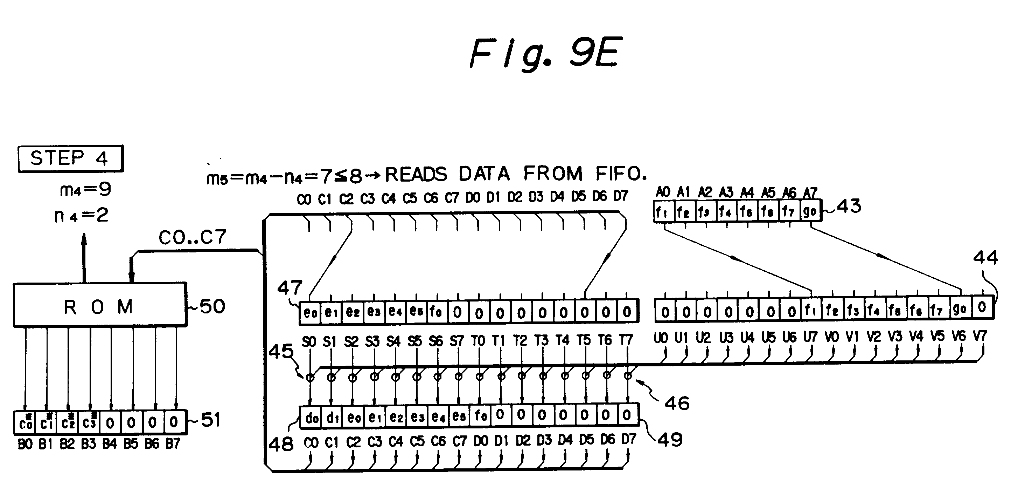

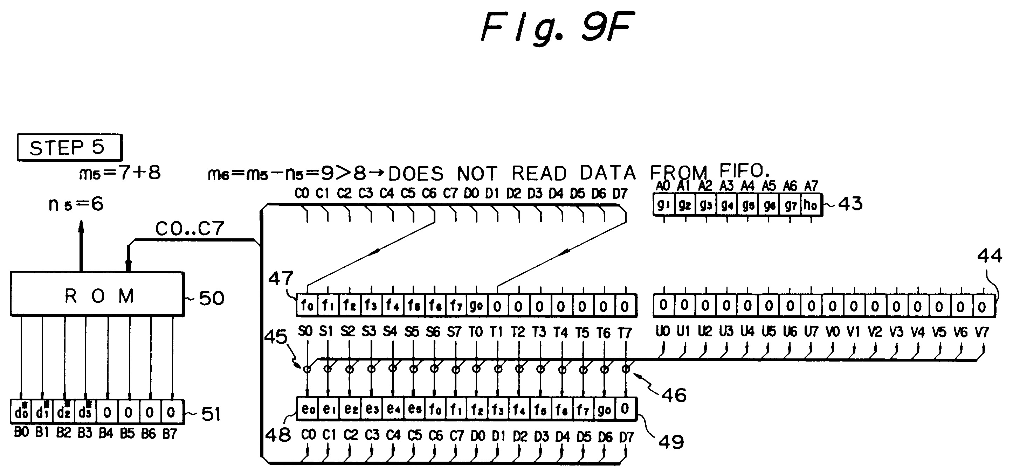

The operations from the step 0 to the step 3 where the 2 bits of data d0 and d1, the 6 bits of data e0 to e5, the 8 bits of data f0 to f7, the 8 bits of data g0 to g7, the 1 bit of data h0, the 4 bits of data k0 to k3, the 6 bits of data 10 to 15, the 2 bits of data p0 and p1, the 1 bit of data q0, the 3 bits of data r0 to r2, the 2 bits of data x0 and x1, the 1 bit of data y0, the 6 bits of data z0 to z5, the 4 bits of data w0 to w5, the 8 bits of data u0 to u7, and the 8 bits of data v0 to v7 are decoded are the same as those from the step 0 to step 12. The output signals of the step 4 to step 12 are the same as those shown in Figs. 9E to 9M. The detail description of such operations are omitted.

### f. Example of modification

In the above embodiments, processes for coefficient data generated in DCT were described. However, they may be applied in the cases where variable length codes generated in high efficiency coding processes other than DCT are processed.

According to the present invention, data coded in variable length is processed as parallel data. Data is converted into parallel data where a constant bit number (for example, 8 bits) is 1 word. In addition, data of a particular bit number is processed as it is, namely as parallel data. Since a delimitation of each variable length code is detected by the constant bit number and each variable length code is decoded, the clock frequency of this process is lower than that where data is processed as serial data. Thus, it is possible to use a process circuit which operates at a low speed. Having described a specific preferred embodiment of the present invention with reference to the accompanying drawings, it is to be understood that the invention is not limited to that precise embodiment, and that various changes and modifications may be effected therein by one skilled in the art without departing from the scope of the invention as defined in the appended claims.

## Claims

1. A coding apparatus for coding variable length data into fixed length words of n bits comprising:
first register means (13) for receiving variable length data of up to m bits;
shifter means (15) for bit shifting data output from said first register means (13) in accordance with a control signal (mk) ;
composing means (20,21) for logically combining data output from said shifter means (15) with preceding data output from the composing means;
output means (22) for outputting the most significant n bits of the output data of said composing means (20,21) when the number of bits of the output data from said composing means (20,21) exceeds n bits; and
control signal generating means (16,17,18) for generating said control signal (mk) in accordance with modulo n of the number of bits of the output data from said composing means (20,21);
said variable length data being thereby converted into data rearranged in n bit words.

2. A coding apparatus for variable length data as set forth in claim 1, wherein:
said composing means includes second register means (23,25), wherein when preceding logically combined data stored in said second register means (23,25) is less than n bits, the preceding logically combined data and succeeding data output from said shifter means (15) are logically combined and stored in said second register means (23,25), and when said preceding logically combined data exceeds n bits, bit data exceeding the n bits of the preceding logically combined data and the succeeding data output from said shifter means (15) are logically combined and stored in said second register means (23,25).

3. A decoding apparatus for receiving data rearranged into n bit words and for decoding it into original data corresponding to variable length data, comprising:
first shifter means (44) for shifting every n bits of received data by an amount in accordance with a control signal (mk+1);
composing means (45,46) for logically combining the shifted data with preceding data output from the composing means (45,46);
decoding means (50) supplied with said logically combined data comprising up to m bits of data, for outputting original data corresponding to the variable m-bit length data, and for outputting information indicating the number of bits of said variable length data; and
control signal generating means (53-56,58,60 and 62) for generating said control signal (mk+1) in accordance with said information indicating the number of bits of said variable length data.

4. A decoding apparatus as set forth in claim 3, wherein;
said control signal generating means (53-56,58,60 and 62) generates said control signal (mk+1) by subtracting said information indicating the number of bits of said variable length data (nk) from the preceding control signal (mk).

5. A decoding apparatus as set forth in claim 3 or 4, wherein:
said preceding data output from the composing means comprises data from the preceding logical combination operation from which a number of bits have been removed in accordance with said information indicating the number of bits of said variable length data, wherein the removal of said number of bits is performed by a second shifter means (47).

6. A decoding apparatus as set forth in claim 5, further comprising means (61,66) for zero resetting the data output of said first shifter means (44) when the data output from the composing means (45,46) exceeds the maximum bit length of said variable length data.

## Patentansprüche

1. Codiervorrichtung zur Codierung von Daten variabler Länge in Worte mit einer festen Länge von n Bits, mit
einer ersten Registereinrichtung (13) zum Empfangen von Daten variabler Länge von bis zu m Bits,
einer Verschiebevorrichtung (15) zum bitweisen Verschieben von von der ersten Registervorrichtung (13) ausgegebenen Daten in Übereinstimmung mit einem Steuersignal (mk),
einer Kombiniervorrichtung (20,21) zum logischen Kombinieren von von der Verschiebevorrichtung (15) ausgegebenen Daten mit vorhergehenden von der Kombiniervorrichtung ausgegebenen Daten,
einer Ausgabevorrichtung zum Ausgeben der höchstwertigen n Bits der Ausgabedaten der Kombiniervorrichtung (20,21), wenn die Anzahl der Bits der Ausgabedaten von der Kombiniervorrichtung (20,21)n Bits überschreitet, und
einer Steuersignal-Erzeugungsvorrichtung (16,17,18) zur Erzeugung des Steuersignales (mk) in Übereinstimmung mit Modulo n der Anzahl von Bits der Ausgabedaten von der Kombiniervorrichtung (20,21),
wobei die Daten variabler Länge dadurch in Daten umgewandelt werden, die in n-Bit-Worte umsortiert sind.

2. Codiervorrichtung für Daten variabler Länge gemäß Anspruch 1, wobei die Kombiniervorrichtung eine zweite Registereinrichtung (23,25) umfaßt, wobei, wenn vorhergehende logisch kombinierte in der zweiten Registervorrichtung (23,25) gespeicherte Daten kürzer sind als n Bits, die vorhergehenden logisch kombinierten Daten und darauffolgende von der Verschiebevorrichtung (15) ausgegebene Daten logisch kombiniert und in der zweiten Registervorrichtung (23,25) gespeichert werden, und wenn die vorhergehenden logisch kombinierten Daten n Bits überschreiten, Bitdaten, die die n Bits der vorhergehenden logisch kombinierten Daten überschreiten, und die darauffolgenden von der Verschiebevorrichtung (15) ausgegebenen Daten logisch kombiniert und in der zweiten Registervorrichtung (23,25) gespeichert werden.

3. Decodiervorrichtung zum Empfangen von in n-Bit-Worte umsortierte n Daten und zu deren Decodieren in ursprüngliche Daten, die Daten variabler Länge entsprechen, mit einer ersten Verschiebevorrichtung (44) zum Verschieben von jeweils n Bits von empfangenen Daten um eine Größe in Übereinstimmung mit einem Steuersignal (mk+1),
einer Kombiniervorrichtung (45,46) zum logischen Kombinieren der verschobenen Daten mit vorhergehenden von der Kombiniervorrichtung (45,46) ausgegebenen Daten, einer Decodiervorrichtung (50), der die logisch kombinierten Daten zugeführt werden, die bis zu m Bits an Daten umfassen, zum Ausgeben ursprünglicher Daten, die den Daten variabler m-Bit-Länge entsprechen, und zum Ausgeben von Informationen, die die Anzahl der Bits der Daten variabler Länge anzeigen, und
einer Steuersignal-Erzeugungsvorrichtung (53-56,58,60 und 62) zum Erzeugen des Steuersignales (mk+1) in Übereinstimmung mit der Information, die die Anzahl von Bits der Daten variabler Länge anzeigt.

4. Decodiervorrichtung gemäß Anspruch 3, wobei
die Steuersignal-Erzeugungsvorrichtung (53-56,58,60 und 62) das Steuersignal (mk+1) durch Abziehen der Information, die die Anzahl der Bits der Daten (nk) variabler Länge anzeigt, von dem vorhergehenden Steuersignal (mk) erzeugt.

5. Decodiervorrichtung gemäß Anspruch 3 oder 4, wobei
die vorhergehenden von der Kombiniervorrichtung ausgegebenen Daten Daten von dem vorhergehenden logischen Kombinationsschritt umfassen, von denen eine Anzahl von Bits in Übereinstimmung mit der Information entfernt wurden, die die Anzahl der Bits der Daten variabler Länge anzeigt, wobei das Entfernen der Anzahl von Bits durch eine zweite Verschiebevorrichtung (47) durchgeführt wird.

6. Decodiervorrichtung gemäß Anspruch 5, weiterhin aufweisend eine Vorrichtung (61,66) zum Zurücksetzen der von der ersten Verschiebeeinrichtung (44) ausgegebenen Daten auf Null, wenn die von der Kombiniervorrichtung (45,46) ausgegebenen Daten die maximale Bitlänge der Daten variabler Länge überschreiten.

## Revendications

1. Appareil de codage pour coder des données de longueur variable en mots de longueur fixe de n bits comprenant:
un premier moyen de registre (13) pour recevoir des données de longueur variable jusqu'à m bits;
un moyen de circuit à décalage (15) pour décaler les bits des données de sortie dudit premier moyen de registre (13) conformément à un signal de commande (mk);
un moyen de composition (20,21) pour combiner logiquement les données de sortie dudit moyen de circuit à décalage (15) avec des données précédentes sorties du moyen de composition;
un moyen de sortie (22) pour sortir les n bits de poids fort des données de sortie dudit moyen de composition (20,21) quand le nombre de bits des données de sortie dudit moyen de composition (20,21) dépasse n bits; et,
un moyen de génération de signaux de commande (16,17,18) pour engendrer ledit signal de commande (mk) conformément à un modulo n du nombre de bits des données de sortie dudit moyen de composition (20,21);
lesdites données de longueur variable étant ainsi converties en données redisposées en mots de n bits.

2. Appareil de codage pour coder des données de longueur variable selon la revendication 1, dans lequel:
ledit moyen de composition comprend un second moyen de registre (23,25) dans lequel, quand des données combinées logiquement précédentes enregistrées dans ledit second moyen de registre (23,25) sont en nombre inférieur à n bits, les données combinées logiquement précédentes et des données suivantes sorties dudit moyen de circuit à décalage (15) sont combinées logiquement et enregistrées dans ledit second moyen de registre (23,25) et, quand lesdites données combinées logiquement précédentes dépassent n bits, les bits de données dépassant les n bits des données combinées logiquement précédentes et les données suivantes sorties dudit moyen de circuit à décalage (15) sont combinés logiquement et enregistrés dans ledit second moyen de registre (23,25).

3. Appareil de décodage pour recevoir des données redisposées en mots de n bits et pour les décoder en données d'origine correspondant à des données de longueur variable, comprenant:
un premier moyen de circuit à décalage (44) pour décaler chaque groupe de n bits de données reçues d'une quantité conformément à un signal de commande (mk+1);
un moyen de composition (45,46) pour combiner logiquement les données décalées avec des données précédentes sorties du moyen de composition (45,46);
un moyen de décodage (50) auquel sont fournies lesdites données combinées logiquement comprenant jusqu'à m bits de données, pour sortir des données d'origine correspondant aux données de longueur de m bits variable, et pour sortir des informations indiquant le nombre de bits desdites données de longueur variable; et,
un moyen de génération de signaux de commande (53-56,58,60 et 62) pour engendrer ledit signal de commande (mk+1) conformément auxdites informations indiquant le nombre de bits desdites données de longueur variable.

4. Appareil de décodage selon la revendication 3, dans lequel:
ledit moyen de génération de signaux de commande (53-56,58,60 et 62) engendre ledit signal de commande (mk+1) en soustrayant lesdites informations indiquant le nombre de bits desdites données de longueur variable (nk) du signal de commande précédent (mk).

5. Appareil de décodage selon l'une quelconque des revendications 3 et 4, dans lequel:
lesdites données précédentes sorties du moyen de composition comprennent des données de l'opération de combinaison logique précédente desquelles un nombre de bits a été retiré conformément auxdites informations indiquant le nombre de bits desdites données de longueur variable, où le retrait dudit nombre de bits est exécuté par un second moyen de circuit à décalage (47).

6. Appareil de décodage selon la revendication 5, comprenant en outre un moyen (61,66) pour remettre à zéro les données sorties dudit premier moyen de circuit à décalage (44) quand les données sorties du moyen de composition (45,46) dépassent la longueur maximale en bits desdites données de longueur variable.
